# EUROPÄISCHE PATENTANMELDUNG

(11) **EP 1 291 916 A2**
(43) Veröffentlichungstag der Anmeldung: **12.03.2003**
(21) Anmeldenummer: 02019821.4
(22) Anmeldetag: 05.09.2002
(51) Int. Cl.: H01L 23/495

(54) **Elektrisches Modul**

(30) Priorität: 10.09.2001 DE 10144324
(71) Anmelder: Delphi Technologies, Inc., Troy, MI 48007 (US)
(72) Erfinder: Gärtner, Markus, 42855 Remscheid (DE); Giesen, Marko, 51588 Nümbrecht (DE); Trommer, Frank O., 51588 Nümbrecht (DE); Stadler, Peter, 57482 Wenden (DE); Schulte, Thomas, 58540 Meinerzhagen Winderbruch (DE)
(74) Vertreter: Manitz, Finsterwald & Partner GbR

(57) **Zusammenfassung**

Ein elektrisches Modul, insbesondere Leistungsmodul, umfaßt eine aus wenigstens einem Metallstanzteil wie insbesondere einem Metallstanzgitter oder Stanzbiegegitter gebildete Leiterstruktur, die einerseits wärmeleitend mit einer Wärmesenke und andererseits sowohl wärmeleitend als auch elektrisch mit wenigstens einem elektrischen Leistungselement und/oder wenigstens einem wärmeerzeugenden elektrischen Bauelement verbunden ist.

## Beschreibung

Die Erfindung betrifft ein elektrisches Modul und insbesondere ein elektrisches Leistungsmodul.

Bei den bisher üblichen, beispielsweise Leistungsmosfets oder wärmeerzeugende elektrische Bauelemente umfassenden Leistungsmodulen besteht das Substrat aus einem hitzebeständigen Material wie Keramik oder dergleichen.

Ziel der Erfindung ist es, ein verbessertes elektrisches Modul, insbesondere elektrisches Leistungsmodul, zu schaffen, das im Aufbau möglichst einfach und kompakt gehalten werden kann und bei dem dennoch eine optimale Wärmeabfuhr gewährleistet ist.

Diese Aufgabe wird erfindungsgemäß gelöst durch ein elektrisches Modul, insbesondere Leistungsmodul, mit einer aus wenigstens einem Metallstanzteil gebildeten Leiterstruktur, die einerseits wärmeleitend mit einer Wärmesenke und andererseits sowohl wärmeleitend als auch elektrisch mit wenigstens einem elektrischen Leistungselement und/oder wenigstens einem wärmeerzeugenden elektrischen Bauelement verbunden ist. Dabei umfaßt die Leiterstruktur vorzugsweise wenigstens ein Stanzbiegegitter.

Aufgrund dieser Ausbildung ist eine optimale Wärmeabfuhr sichergestellt und eine höhere Packungsdichte möglich. Die aus wenigstens einem Metallstanzteil wie insbesondere einem Metallstanzgitter oder Stanzbiegegitter gebildete Leiterstruktur kann höhere Ströme führen und besitzt einen relativ kleinen elektrischen Widerstand. Durch das Metallstanzgitter wird die Wärme verteilt und ein ausgedehnter Bereich geschaffen, von dem aus die Wärme in die Wärmesenke abgeführt werden kann. Die betreffende Leiterstruktur ist einerseits wärmeleitend mit der Wärmesenke verbunden und dient andererseits gleichzeitig dem elektrischen Anschluß. So kann ein jeweiliges elektrisches Leistungs- bzw. Bauelement z. B. mit einer Anschlußseite auf das Metallstanzgitter aufgesetzt werden. Dabei kann diese aus wenigstens einem Metallstanzteil wie insbesondere einem Metallstanzgitter bestehende Leiterstruktur insbesondere ein Massepotential aufweisen und beispielsweise der Energieversorgung dienen. Es ist nicht nur eine höhere Packungsdichte möglich, es ergibt sich insgesamt auch eine verbesserte Wärmeverteilung und -abfuhr. Dabei sind insbesondere auch keine zusätzlichen wärmeerzeugenden Leitungen mehr erforderlich.

Die aus wenigstens einem Metallstanzteil wie insbesondere einem Metallstanzgitter gebildete Leiterstruktur kann insbesondere über ein wärmeleitendes, elektrisch isolierendes Medium fest mit der Wärmesenke verbunden sein. Das betreffende Medium ist vorzugsweise auch so zu wählen, daß die erforderliche mechanische Festigkeit sichergestellt ist.

Dabei kann die Leiterstruktur beispielsweise über eine wärmeleitende, elektrisch isolierende Folie oder über einen wärmeleitenden, elektrisch isolierenden Kleber fest mit der Wärmesenke verbunden sein. Die Isolierfunktion kann grundsätzlich jedoch z. B. auch durch eine entsprechende Beschichtung des Kühlkörpers (z. B. Eloxatschicht) oder der Leiterstruktur erfüllt werden.

Mit den elektrischen Leistungselementen bzw. wärmeerzeugenden elektrischen Bauelementen ist die Leiterstruktur vorzugsweise über ein sowohl wärmeleitendes als auch ein elektrisch leitendes Medium fest verbunden. Auch in diesem Fall ist das betreffende Medium wieder zweckmäßigerweise so zu wählen, daß die erforderliche mechanische Festigkeit sichergestellt ist.

Dabei kann die Leiterstruktur beispielsweise über einen sowohl wärmeleitenden als auch elektrisch leitenden Kleber fest mit den jeweiligen elektrischen Leistungselementen bzw. wärmeerzeugenden elektrischen Bauelementen verbunden sein. Die betreffende elektrische Verbindung kann beispielsweise auch durch ein Lot bewerkstelligt werden. Grundsätzlich sind auch andere Verbindungsarten möglich.

Die Leiterbahnen der Leiterstruktur können sich in einer oder auch in mehreren Ebenen erstrecken.

Gemäß einer bevorzugten praktischen Ausführungsform des erfindungsgemäßen elektrischen Moduls ist wenigstens ein elektrisches Leistungselement bzw. wärmeerzeugendes elektrisches Bauelement durch einen IC-Chip gebildet. Dabei ist insbesondere eine kompakte Anordnung aus mehreren solchen IC-Chips möglich, denen dann ein einziges gemeinsames Gehäuse zugeordnet werden kann. Im Ergebnis wird somit eine hohe Pakkungsdichte erzielt.

Es können u. a. beispielsweise ein oder mehrere Silicium-Chips vorgesehen.

Gemäß einer bevorzugten praktischen Ausführungsform des erfindungsgemäßen elektrischen Moduls ist wenigstens ein elektrisches Leistungs element durch einen Mosfet bzw. Mosfet-Chip gebildet.

Vorzugsweise ist eine Vielzahl von elektrischen Leistungselementen und/oder wärmeerzeugenden elektrischen Bauelementen mit der Leiterstruktur verbunden. Dabei kann insbesondere eine Vielzahl von Mosfets bzw. Mosfet-Chips mit der Leiterstruktur verbunden sein.

Bei Leistungselementen wie insbesondere Mosfets bildet der im leitenden oder eingeschalteten Zustand gegebene Innenwiderstand, z. B. bei Mosfets der Drain/Source-Widerstand, eine Wärmequelle. Indem die zunächst gehäuselosen IC-Chips, d. h. insbesondere Mosfet-Chips auf der aus wenigstens einem Metallstanzteil wie insbesondere einem Metallstanzgitter gebildeten Leiterstruktur montiert werden, wird die von den ICs erzeugte Wärme über die Leiterstruktur optimal verteilt und schließlich in die Wärmesenke abgeführt. Angesichts des minimalen elektrischen Widerstands der Leiterstruktur wird nur in geringem Maße zusätzliche Wärme erzeugt. Indem mit der Leiterstruktur eine Wärmesenke verbunden ist, kann die von den ICs bzw. Mosfets erzeugte Wärme direkt über eine große Fläche abgeführt werden, wobei gleichzeitig über die Leiterstruktur für einen elektrischen Anschluß gesorgt ist. Die verschiedenen IC-Chips können schließlich in einem einzigen gemeinsamen Gehäuse untergebracht werden.

Die Leiterstruktur besteht zweckmäßigerweise aus einer Kupferlegierung.

Die Wärmesenke kann vorteilhafterweise einen gerippten Kühlkörper umfassen.

Die Leiterstruktur kann zunächst in ein Isoliermaterial eingebettet sein. Dazu kann beispielsweise ein entsprechendes Isoliermaterial auf die Leiterstruktur aufgespritzt werden. Auf dem Isoliermaterial auf der einen Seite der Leiterstruktur kann z. B. eine Trägerplatte, z. B. eine herkömmliche Leiterplatte aufgebracht sein.

Die restlichen elektrischen Verbindungen der mit der Leiterstruktur verbundenen elektrischen Leistungselemente bzw. Bauelemente können beispielsweise durch Bonden oder dergleichen hergestellt werden.

Die Erfindung wird im folgenden anhand eines Ausführungsbeispiels unter Bezugnahme auf die Zeichnungen näher erläutert; in dieser zeigen:
- Fig. 1: eine schematische perspektivische Teildarstellung eines elektrischen Moduls,
- Fig. 2: eine stark vereinfachte schematische Darstellung des Grundaufbaus des elektrischen Moduls der Figur 1,
- Fig. 3: eine schematische perspektivische Darstellung eines z. B. mit IC-Chips bestückten randseitigen Teils der Leiterstruktur des elektrischen Moduls der Figur 1 und
- Fig. 4: eine schematische Ansicht des elektrischen Moduls der Figur 1 von unten.

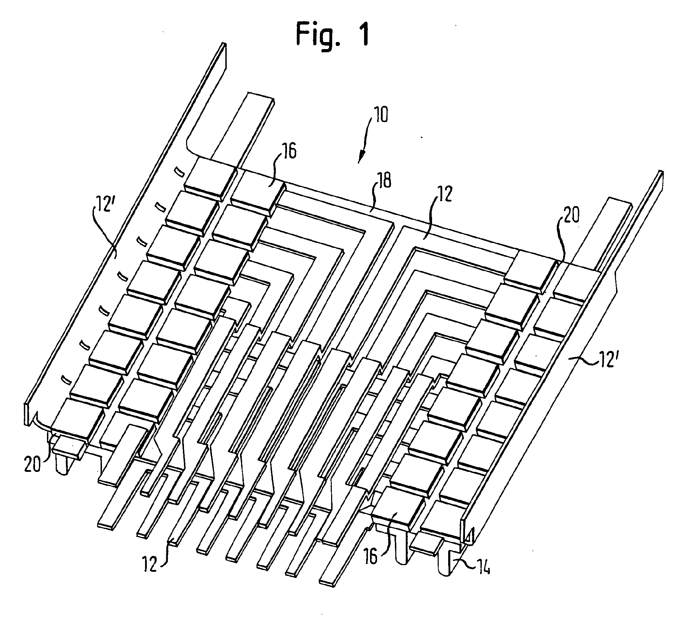

Figur 1 zeigt in schematischer perspektivischer Teildarstellung ein elektrisches Modul 10, bei dem es sich insbesondere um ein elektrisches Leistungsmodul handeln kann.

Das elektrische Modul 10 umfaßt eine aus wenigstens einem Metallstanzteil wie beispielsweise einem Metallstanzgitter oder Stanzbiegegitter gebildete Leiterstruktur 12. Diese Leiterstruktur 12 ist einerseits wärmeleitend mit einer Wärmesenke 14 und andererseits sowohl wärmeleitend als auch elektrisch mit einer Vielzahl von elektrischen Leistungselementen, im vorliegenden Fall einer Vielzahl von IC-Chips 16, verbunden. Dabei kann es sich bei den IC-Chips 16 beispielsweise um Mosfet-Chips und insbesondere um Leistungsmosfet-Chips handeln. Alternativ oder zusätzlich kann die insbesondere durch wenigstens ein Metallstanzgitter gebildete Leiterstruktur 12 z. B. auch mit einer oder mehreren wärmeerzeugenden elektrischen Bauelemente verbunden sein.

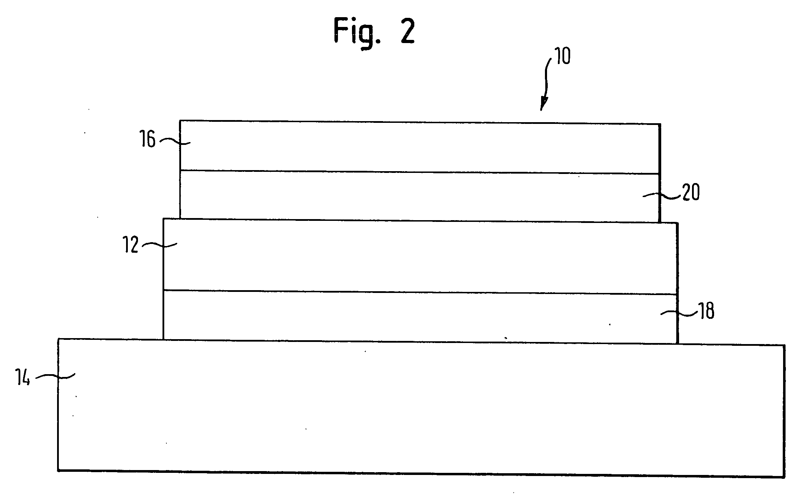

Der Grundaufbau des elektrischen Moduls 10 ist in stark vereinfachter schematischer Darstellung auch nochmals in der Figur 2 gezeigt.

Danach ist die aus wenigstens einem Metallstanzteil gebildete Leiterstruktur über ein wärmeleitendes, elektrisch isolierendes Medium 18 fest mit der Wärmesenke 14 verbunden. Dabei ist das Medium 18 zweckmäßigerweise auch so gewählt, daß die gewünschte mechanische Festigkeit sichergestellt ist.

Bei dem betreffendem, zwischen der Leiterstruktur 12 und der Wärmesenke 14 vorgesehenen Medium 18 kann es sich beispielsweise um eine wärmeleitende, elektrisch isolierende Folie oder um einen wärmeleitenden, elektrisch isolierenden Kleber und/oder dergleichen handeln.

Die hier beispielsweise durch IC-Chips gebildeten elektrischen Leistungselemente 16 sind über ein sowohl wärmeleitendes als auch elektrisch leitendes Medium 20 fest mit der Leiterstruktur 12 verbunden. Auch in diesem Fall ist das Medium 20 zweckmäßigerweise wieder so gewählt, daß gleichzeitig auch die gewünschte mechanische Festigkeit sichergestellt ist.

Bei dem zwischen der Leiterstruktur 12 und den elektrischen Leistungselementen 16, z. B. IC-Chips wie beispielsweise Silicium-Chips vorgesehenen Medium 20 kann es sich beispielsweise um einen sowohl wärmeleitenden als auch elektrisch leitenden Kleber, Lot oder dergleichen handeln.

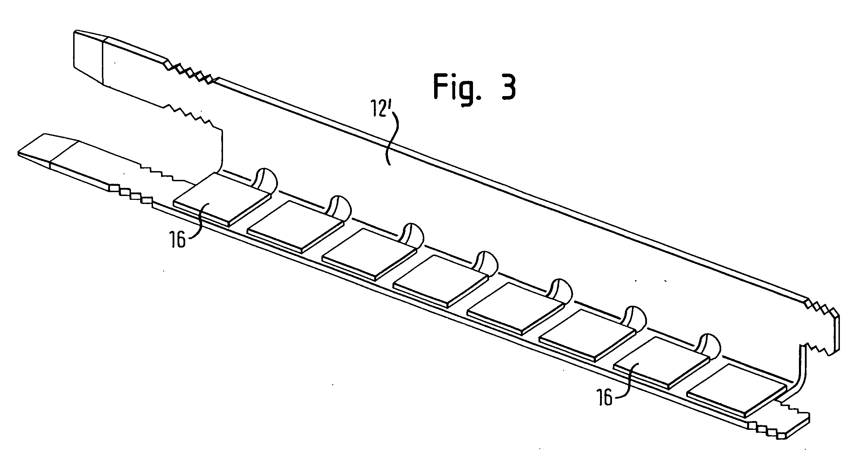

Figur 3 zeigt in schematischer perspektivischer Darstellung ein beispielsweise wieder mit mehreren elektrischen Leistungselementen wie insbesondere IC-Chips bestückten randseitigen Teil 12' der Leiterstruktur 12 des in der Figur 1 gezeigten elektrischen Moduls 10. Wie anhand dieser Figur 3 zu erkennen ist, ist das betreffende randseitige Leiterteil 12' zumindest im wesentlichen rechtwinklig abgebogen.

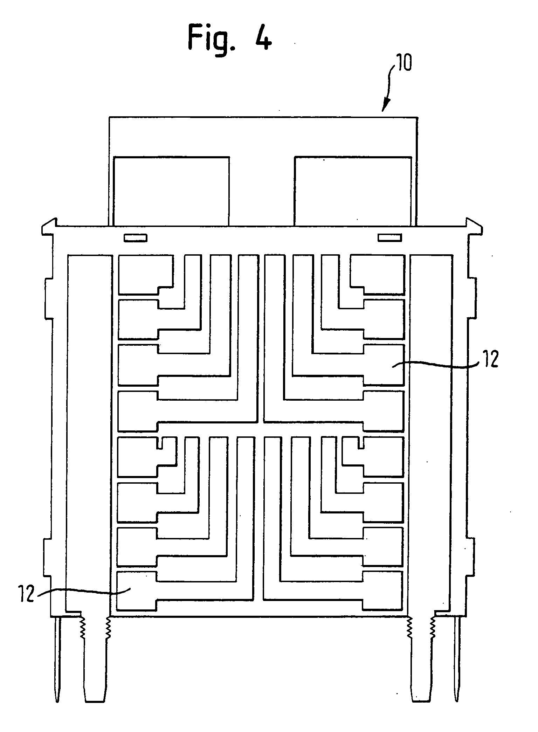

Figur 4 zeigt in schematischer Ansicht den elektrischen Modul 10 der Figur 1 von unten.

In den Figuren sind einander entsprechenden Teilen gleiche Bezugszeichen zugeordnet.

Wie am besten anhand der Figuren 1 und 4 zu erkennen ist, erstrecken sich die Leiterbahnen der aus wenigstens einem Metallstanzteil wie insbesondere einem Metallstanzgitter oder dergleichen gebildeten Leiterstruktur 12 in mehreren Ebenen. Grundsätzlich ist jedoch auch eine solche Anordnung denkbar, bei der sich die Leiterbahnen der Leiterstruktur lediglich in einer Ebene erstrecken.

Gemäß den Figuren 1 bis 4 kann eine Vielzahl von elektrischen Leistungselementen 16, z. B. IC-Chips wie beispielsweise Silicium-Chips, mit der Leiterstruktur 12 verbunden sein. Die zunächst gehäuselosen IC-Chips, z. B. Mosfet-Chips, können also in einem einzigen gemeinsamen Gehäuse untergebracht werden, wodurch eine relativ hohe Packungsdichte ermöglicht wird.

Die Leiterstruktur 12 kann insbesondere aus einer Kupferlegierung bestehen.

Wie insbesondere der Figur 1 entnommen werden kann, kann die Wärmesenke 14 beispielsweise einen gerippten Kühlkörper umfassen.

Die aus wenigstens einem Metallstanzteil wie insbesondere einem Metallstanzgitter oder dergleichen gebildete Leiterstruktur 12 kann relativ hohe Ströme führen und besitzt einen relativ kleinen elektrischen Widerstand. Durch die Leiterstruktur 12 wird die von den elektrischen Leistungselementen 16 erzeugte Wärme verteilt, so daß ein ausgedehnter Bereich geschaffen wird, über den die Wärme an die Wärmesenke 14 abgeführt werden kann. Die Leiterstruktur 12 ist nicht nur mit der Wärmesenke 14 verbunden, sie dient gleichzeitig auch dem elektrischen Anschluß der elektrischen Leistungselemente 16. Dabei kann die Leiterstruktur 12 insbesondere ein Massepotential aufweisen und beispielsweise der Energieversorgung dienen. Es sind keine zusätzlichen wärmeerzeugenden Leitungen erforderlich. Werden mit der Leiterstruktur 12 gehäuselose IC-Chips verbunden, die schließlich in einem einzigen gemeinsamen Gehäuse untergebracht werden können, so ergibt sich eine relativ hohe Packungsdichte, wobei gleichzeitig für eine optimale Wärmeverteilung und -abfuhr gesorgt ist.

### Bezugszeichenliste

- 10: elektrisches Modul, elektrisches Leistungsmodul
- 12: Leiterstruktur, Metallstanzgitter, Stanzbiegegitter
- 12': Teil der Leiterstruktur
- 14: Wärmesenke
- 16: elektrisches Leistungselement, IC-Chip, Mosfet-Chip
- 18: wärmeleitendes, isolierendes Medium
- 20: wärmeleitendes und elektrisch leitendes Medium

## Patentansprüche

1. Elektrisches Modul (10), insbesondere Leistungsmodul, mit einer aus wenigstens einem Metallstanzteil gebildeten Leiterstruktur (12), die einerseits wärmeleitend mit einer Wärmesenke (14) und andererseits sowohl wärmeleitend als auch elektrisch mit wenigstens einem elektrischen Leistungselement (16) und/oder wenigstens einem wärmeerzeugenden elektrischen Bauelement verbunden ist.

2. Elektrisches Modul nach Anspruch 1,
**dadurch gekennzeichnet,**
**daß** die Leiterstruktur (12) wenigstens ein Metallstanzgitter oder Stanzbiegegitter umfaßt.

3. Elektrisches Modul nach Anspruch 1 oder 2,
**dadurch gekennzeichnet,**
**daß** die Leiterstruktur (12) über ein wärmeleitendes, elektrisch isolierenden Medium (18) fest mit der Wärmesenke (14) verbunden ist.

4. Elektrisches Modul nach Anspruch 2,
**dadurch gekennzeichnet,**
**daß** die Leiterstruktur (12) über eine wärmeleitende, elektrisch isolierende Folie (18) fest mit der Wärmesenke (14) verbunden ist.

5. Elektrisches Modul nach Anspruch 2,
**dadurch gekennzeichnet,**
**daß** die Leiterstruktur (12) über einen wärmeleitenden, elektrisch isolierenden Kleber (18) fest mit der Wärmesenke (14) verbunden ist.

6. Elektrisches Modul nach einem der vorhergehenden Ansprüche,
**dadurch gekennzeichnet,**
**daß** die Leiterstruktur (12) über ein sowohl wärmeleitendes als auch elektrisch leitendes Medium (20) fest mit dem elektrischen Leistungselement (16) bzw. wärmeerzeugenden elektrischen Bauelement verbunden ist.

7. Elektrisches Modul nach Anspruch 5,
**dadurch gekennzeichnet,**
**daß** die Leiterstruktur (12) über einen sowohl wärmeleitenden als auch elektrisch leitenden Kleber fest mit dem elektrischen Leistungselement (16) bzw. wärmeerzeugenden elektrischen Bauelement verbunden ist.

8. Elektrisches Modul nach einem der vorhergehenden Ansprüche,
**dadurch gekennzeichnet,**
**daß** sich die Leiterbahnen der Leiterstruktur (12) in mehreren Ebenen erstrecken.

9. Elektrisches Modul nach einem der Ansprüche 1 bis 6,
**dadurch gekennzeichnet,**
**daß** sich die Leiterbahnen der Leiterstruktur (12) in einer Ebene erstrecken.

10. Elektrisches Modul nach einem der vorhergehenden Ansprüche,
**dadurch gekennzeichnet,**
**daß** wenigstens ein elektrisches Leistungselement (16) bzw. wärmeerzeugendes elektrisches Bauelement durch einen IC-Chip gebildet ist.

11. Elektrisches Modul nach Anspruch 9,
**dadurch gekennzeichnet,**
**daß** der IC-Chip (16) durch einen Silizium-Chip gebildet ist.

12. Elektrisches Modul nach einem der vorhergehenden Ansprüche,
**dadurch gekennzeichnet,**
**daß** wenigstens ein elektrisches Leistungselement (16) durch einen Mosfet bzw. Mosfet-Chip gebildet ist.

13. Elektrisches Modul nach einem der vorhergehenden Ansprüche,
**dadurch gekennzeichnet,**
**daß** eine Vielzahl von elektrischen Leistungselementen (16) und/oder wärmeerzeugenden elektrischen Bauelementen mit der Leiterstruktur (12) verbunden ist.

14. Elektrisches Modul nach Anspruch 12,
**dadurch gekennzeichnet,**
**daß** eine Vielzahl von Mosfets bzw. Mosfet-Chips (16) mit der Leiterstruktur (12) verbunden ist.

15. Elektrisches Modul nach einem der vorhergehenden Ansprüche,
**dadurch gekennzeichnet,**
**daß** die Leiterstruktur (12) aus einer Kupferlegierung besteht.

16. Elektrisches Modul nach einem der vorhergehenden Ansprüche,
**dadurch gekennzeichnet,**
**daß** Wärmesenke (14) einen gerippten Kühlkörper umfaßt.
